# EUROPÄISCHE PATENTSCHRIFT

(11) **EP 2 486 604 B1**
(45) Veröffentlichungstag und Bekanntmachung des Hinweises auf die Patenterteilung: **19.06.2019**
(21) Anmeldenummer: 10763651.6
(22) Anmeldetag: 27.09.2010
(51) Int. Cl.: H01L 33/50, H01L 33/62

(54) **KONTAKTIERUNG EINES OPTOELEKTRONISCHEN HALBLEITERBAUTEILS DURCH KONVERSIONSELEMENT**
CONTACTING AN OPTOELECTRONIC SEMICONDUCTOR COMPONENT THROUGH A CONVERSION ELEMENT
MISE EN CONTACT D'UN COMPOSANT SEMI-CONDUCTEUR OPTOÉLECTRONIQUE PAR UN ÉLÉMENT DE CONVERSION

(30) Priorität: 06.10.2009 DE 102009048401
(43) Veröffentlichungstag der Anmeldung: 15.08.2012
(73) Patentinhaber: OSRAM Opto Semiconductors GmbH, 93055 Regensburg (DE)
(72) Erfinder: GALLMEIER, Hans-Christoph, 93049 Regensburg (DE); KRUPPA, Michael, 93055 Regensburg (DE); SCHWARZ, Raimund, 93053 Regensburg (DE); SPATH, Guenter, 93047 Regensburg (DE)
(86) Internationale Anmeldenummer: PCT/EP2010/064241
(87) Internationale Veröffentlichungsnummer: WO 2011/042325

(56) Entgegenhaltungen:
- EP-A1- 1 118 259
- WO-A1-2009/046576
- WO-A2-2004/040661
- WO-A2-2008/104936
- WO-A2-2009/048704
- WO-A2-2009/075972
- DE-A1-102007 053 067
- DE-A1-102008 005 497
- US-A1- 2007 221 867

## Beschreibung

Die vorliegende Erfindung betrifft ein Verfahren zum Herstellen eines optoelektronischen Halbleiterbauteils.

Ein Beispiel für ein optoelektronisches Halbleiterbauteil weist ein Lumineszenzkonversionselement auf. Ein solches Bauteil ist beispielsweise aus der Druckschrift [1] bekannt. Es umfasst einen optoelektronischen Halbleiterchip, welcher im Betrieb eine Primärstrahlung aussendet, und ein Lumineszenzkonversionselement, in dem ein Teil der Primärstrahlung in eine Sekundärstrahlung anderer Wellenlänge konvertiert wird. Die resultierende Strahlung ergibt sich aus der Überlagerung der vom Lumineszenzkonversionselement transmittierten Primärstrahlung und der erzeugten Sekundärstrahlung. So lassen sich insbesondere Lichtquellen bereitstellen, die ein weißes Licht abstrahlen.

Bei der Herstellung der Halbleiterbauteile ist insbesondere problematisch, dass ein Farbort der Primärstrahlung des Halbleiterchips im Farbraum einer gewissen Fertigungsstreuung unterliegt. Es ist wünschenswert, dass Lumineszenzkonversionselement entsprechend des jeweiligen Farborts zu wählen und dem Halbleiterchip zuzuordnen, um so eine Lichtquelle mit den gewünschten Emissionseigenschaften zu erhalten.

Die Druckschrift WO 2009/048704 A2 ist auf ein Herstellungsverfahren für LEDs mit einem epitaktisch gewachsenen Konversionselement gerichtet.

Aus der Druckschrift US 2007/0221867 A1 ist ein LED-Chip mit einem Konversionselement bekannt, das von elektrischen Kontaktstellen entfernt wurde.

Ein Verfahren, bei dem LED-Chips an einem temporären Träger mit einem Vergussmaterial versehen werden, findet sich in der Druckschrift DE 10 2007 053 067 A1.

Gemäß der Druckschrift US 2006/0003477 A1 werden Kontaktstellen von LED-Chips nach dem Aufbringen eines Konversionsmaterials zum Teil abgetragen.

Der Druckschrift WO 2008/104936 A1 ist zu entnehmen, dass ein Konversionselement mittels Pressen an LED-Chips angebracht werden kann.

In der Druckschrift DE 10 2008 005 497 A1 ist es offenbart, bei der Herstellung von LEDs einen Kunstwafer heranzuziehen.

Ein Sortieren von LED-Chips nach deren Emissionscharakteristik findet sich in der Druckschrift WO 2001/13697 A1.

Der vorliegenden Erfindung liegt das Problem zugrunde, ein optoelektronisches Halbleiterbauteil mit einem angestrebten Farbort herzustellen.

Dieses Problem wird durch ein Verfahren zum Herstellen eines optoelektronischen Halbleiterbauteils gemäß Anspruch 1 gelöst.

Weiterbildungen und vorteilhafte Ausgestaltungen des Verfahrens zum Herstellen eines optoelektronischen Halbleiterbauteils sind in den abhängigen Patentansprüchen angegeben.

### BEISPIELHAFTE AUSFÜHRUNGSFORMEN

Erfindungsgemäß weist das Verfahren zum Herstellen eines optoelektronischen Halbleiterbauteils die folgenden Schritte auf:
- Bereitstellen eines Halbleiterchips in einem Waferverbund mit einer aktiven Seite zum Emittieren einer Primärstrahlung und einem auf der aktiven Seite angeordneten Kontaktanschluss;
- Aufbringen eines Ankopplungselements auf der aktiven Seite;
- Anbringen eines Lumineszenzkonversionselements zum Wandeln eines Teils der Primärstrahlung in eine Sekundärstrahlung auf dem Ankopplungselement.

Verschiedene Ausführungsformen des optoelektronischen Halbleiterbauteils weisen eine Halbleiterschichtfolge mit einer aktiven Seite zur Emission von Primärstrahlung und einem an der aktiven Seite angeordnetem Kontaktanschluss auf. Auf der aktiven Seite ist ein Lumineszenzkonversionselement angeordnet, wobei zwischen der aktiver Seite und Lumineszenzkonversionselement ein Ankopplungselement vorgesehen ist.

Ein Halbleiterchip ist eine in einem Halbleiterprozess erzeugte Schichtabfolge auf einem Halbleitersubstrat. Dabei ist ein Halbleiter, beispielsweise ein III-V Halbleiter, so wie ein GaAs-Halbleiter oder ein GaN-Halbleiter, vorgesehen. Es sind auf einem Substrat aufgewachsene Epitaxieschichten als Halbleiterschichtfolge möglich. Das Substrat umfasst beispielsweise Materialien wie SiC, Saphir, Ge, Si, GaAs, GaN oder GaP. Die Epitaxieschichten weisen beispielsweise quarternäre Halbleiter, wie AlInGaN für ein blau oder grünes Emissionsspektrum im sichtbaren Bereich auf oder AlIn-GaP für ein rotes Emissionsspektrum im sichtbaren Bereich. Ebenso kann die Epitaxieschicht quinternäre Halbleiter aufweisen. Ein solcher Halbleiter ist beispielsweise AlGaInASP, der zur Emission von Strahlung im Infrarotbereich dienen kann.

Nach einer Vereinzelung wird der Halbleiterchip mit elektronischen Kontakten versehen, wobei Prozessschritte wie ein Aufbringen auf einen Leiterrahmen, einen Träger und/oder Anbringen von Bonddrähten (*bonding*) durchgeführt werden können. Nach einem Einbringen des Halbleiterchips in ein Chipgehäuse spricht man von einem Halbleiterbauteil.

Ein Waferverbund ist im folgenden jede Anordnung, die eine Vielzahl von ungehäusten Halbleiterchips aufweist. Dies kann beispielsweise ein Halbleiterwafer sein, insbesondere ein ungesägter Halbleiterwafer, der eine Vielzahl von einzelnen Halbleiterchips aufweist. Ebenso kann der Waferverbund ein Träger sein, auf den eine Vielzahl von ungehäusten aber bereits vereinzelten Halbleiterchips aufgebracht ist, um eine weitere Prozessierung derselben zu ermöglichen. In diesem Fall spricht man auch von einem Kunstwafer (*artifical wafer*). Die Halbleiterchips sind auf dem Träger vorzugsweise fixiert, beispielsweise in dem sie mit einer Vergussmasse wie Silikon umgossen sind. Ebenso können die Halbleiterchips zur Fixierung in Aufnahmen im Träger eingebracht werden.

Das Ankopplungselement dient zum Ankoppeln des Lumineszenzkonversionselements an den Halbleiterchip. Es ist auf der aktiven Seite des optoelektronischen Halbleiterchips angebracht. Bevorzugt weist es eine hohe Photostabilität und eine hohen Hitzestabilität auf. Typischerweise ist das Material transparent über dem von dem optoelektronischen Halbleiterchips emittierten Spektrum. Als typische Ankopplungsmedien kommen Materialien in Betracht, die auch in dem Lumineszenzkonversionselement verwendet werden, insbesondere dort verwendete Matrixmaterialien. Mögliche Materialien für das Ankopplungselement sind photostrukturierbare Materialien und/oder Materialien wie Glas, Silikon, Aluminiumoxid, Klebstoff, *Spin-on-Silicon* (SoS), *Spin-on-Glass* (SoG), Benzocyclobuten (BCB) etc. Das Ankopplungselement kann bspw. als Ankopplungsschicht durch ein Aufschleudern aufgebracht werden.

Unter einem Lumineszenzkonversionselement wird jede Vorrichtung verstanden, in dem ein Teil der von einem Halbleiterchip emittierten Primärstrahlung in eine Strahlung von anderer Wellenlänge konvertiert wird. Diese Strahlung wird als Sekundärstrahlung bezeichnet. Das Lumineszenzkonversionselement wird gesondert von dem Halbleiterchip gefertigt. Es weist beispielsweise die Form eines Plättchens auf, das auf die aktive Seite des Halbleiterchips aufgebracht werden kann. Zur Fixierung des Plättchens dient das Ankopplungselement. In der Regel umfasst das Lumineszenzkonversionselement ein strahlungsdurchlässiges Matrixmaterial und einen in das Matrixmaterial eingebrachten Leuchtstoff. Das Matrixmaterial bestimmt die mechanischen Eigenschaften des Lumineszenzkonversionselements. Als Matrixmaterial kommt insbesondere ein strahlungsstabiles und transparentes Material in Betracht. Für eine Primärstrahlung im sichtbaren Bereicht (Licht) kommt beispielsweise Silikon in Betracht. Das Matrixmaterial kann eine folienartige, flexible Schicht sein. Es ist beispielsweise auch ein thermoplastischer oder duroplastischer Kunststoff. Das Matrixmaterial kann durch ein Trägerelement gestützt oder selbsttragend ausgeführt sein. Üblicherweise wird der Brechungsindex des Matrixmaterials derart gewählt, dass nach einem Anbringen des Lumineszenzkonversionselements auf dem Halbleiterchip keine unerwünschten Streueffekte entstehen. Dabei wird beispielsweise der Brechungsindex des Halbleitermaterials oder einer evtl. vorgesehenen Ankopplungsschicht berücksichtigt.

Ein in dem Matrixmaterial eingebrachter Leuchtstoff absorbiert zumindest einen Teil der Primärstrahlung und emittiert Sekundärstrahlung in einem anderen Wellenlängenbereich. Als Leuchtstoffe werden beispielsweise anorganische Leuchtstoffe verwendet, wie beispielsweise mit seltenen Erden dotierte Granate. Es können ebenso organische Leuchtstoffe, wie Perylen, oder Mischungen aus unterschiedlichen Leuchtstoffen verwendet werden. Eine Vielzahl möglicher Leuchtstoffe ist aus dem Dokument [2] bekannt, dessen Offenbarung hiermit durch Rückbezug in das vorliegende Dokument aufgenommen wird.

Das Lumineszenzkonversionselement kann als flaches Plättchen ausgestaltet sein. Es kann eine Folie sein. Die Austrittsoberfläche des Lumineszenzkonversionselements kann flach gestaltet sein. Ebenso ist es möglich, dass das Lumineszenzkonversionselement eine geeignete Austrittsoberfläche aufweist, um eine gewünschte Lichtauskopplung zu erzielen. Dazu kann das Lumineszenzkonversionselement beispielsweise linsenförmig, bspw. mit einer konvex gekrümmten Austrittsoberfläche, gestaltet sein. Ebenso ist es möglich, dass das Lumineszenzkonversionselement eine glatte oder alternativ eine geeignet aufgraute Austrittsoberfläche aufweist.

Es ist ein Grundgedanke, dass ein Lumineszenzkonversionselement auf einen Halbleiterchip aufgebracht wird, der bereits mit einem Kontaktanschluss versehen ist. Das Aufbringen des Lumineszenzkonversionselements erfolgt, bevor der Halbleiterchip, bspw. mittels eines Bonddrahts, kontaktiert und in einem Gehäuse verkapselt wird. Damit ist insbesondere ein Vertrieb von weißen, ungehäusten Halbleiterchips möglich. Zusätzlich können so Halbleiterchips bereitgestellt werden, die mittels eines Wafer Level Package (WLP) gehäust sind. Beim WLP werden möglichst viele Schritte der Kontaktierung und der Häusung schon auf Wafer-Ebene, also vor der Vereinzelung, durchgeführt. Es entsteht ein Halbleiterbauteil, das nur unwesentlich größer ist als der Halbleiterchip.

Das Lumineszenzkonversionselement wird dabei getrennt von dem Halbleiterchip als einzelnes Element hergestellt. Es wird nachträglich auf die aktive Seite des Halbleiterchips aufgebracht und mittels des Ankopplungselement fixiert. Damit ist es möglich, durch die bereits vorgesehenen Kontaktanschlüsse das Spektrum der Primärstrahlung zu bestimmen und anschließend ein geeignet ausgewähltes Lumineszenzkonversionselement auf die aktive Seite des Halbleiterchips aufzubringen. Die Wahl des Lumineszenzkonversionselements wird dabei derart getroffen, dass ein bestimmter Anteil oder ein bestimmtes Spektrum der Sekundärstrahlung im Lumineszenzkonversionselement erzeugt wird, so dass das sich überlagernde Spektrum der transmittierten Primärstrahlung und der erzeugten Sekundärstrahlung einem gewünschten Emissionsspektrum entspricht. Dadurch ist es möglich, ein optoelektronisches Halbleiterbauteil mit einem angestrebten Farbort herzustellen.

In einer Abwandlung des Verfahrens wird der Kontaktanschlusses freigelegt. Das Freilegen erfolgt beispielsweise durch Laserablation oder durch einen photolithographischen Prozess. Das nachträgliche Freilegen des Kontaktanschlusses erlaubt ein einfaches Aufbringen des Lumineszenzelements. Insbesondere kann das Verfahren dabei derart durchgeführt werden, dass bei dem Aufbringen des Ankopplungselement und des Lumineszenzelement nicht notwendig auf ein Freibleiben des Kontaktanschlusses geachtet werden muss.

### KURZE BESCHREIBUNG DER ZEICHNUNGEN

Verschiedene Abwandlungen und ein Ausführungsbeispiel der erfindungsgemäßen Lösung werden im Folgenden anhand der Zeichnungen näher erläutert. In den Figuren geben die erste(n) Ziffer(n) eines Bezugszeichens die Figur an, in denen das Bezugszeichen zuerst verwendet wird. Die gleichen Bezugszeichen werden für gleichartige oder gleich wirkende Elemente bzw. Eigenschaften in allen Figuren verwendet.

Es zeigen:
- **Fig. 1**: eine schematische Darstellung einer Aufsicht auf einen Waferverbund mit optoelektronischen Halbleiterbauelementen;
- **Fig. 2a bis 2e**: eine schematische Darstellung von Verfahrensschritten einer Abwandlung des Herstellens eines optoelektronischen Halbleiterbauteils anhand eines Ausschnitts durch den in **Fig. 1** gezeigten Waferverbund entlang einer Schnittachse A-A;
- **Fig. 3**: eine schematische Darstellung eines optoelektronischen Halbleiterbauteils;
- **Fig. 4a bis 4e**: eine schematische Darstellung von Verfahrensschritten eines Ausführungsbeispiels zum Herstellen eines optoelektronischen Halbleiterbauteils anhand eines Ausschnitts durch den in **Fig. 1** gezeigten Waferverbund entlang einer Schnittachse A-A;
- **Fig. 5**: ein Ablaufdiagramm einer Abwandlung eines Verfahrens zum Herstellen eines optoelektronischen Halbleiterbauteils;
- **Fig. 6**: ein Ablaufdiagramm eines Ausführungsbeispiels von Verfahrensschritten beim Herstellen eines optoelektronischen Halbleiterbauteils und
- **Fig. 7**: ein Ablaufdiagramm eines Ausführungsbeispiels von Verfahrensschritten beim Herstellen eines optoelektronischen Halbleiterbauteils.

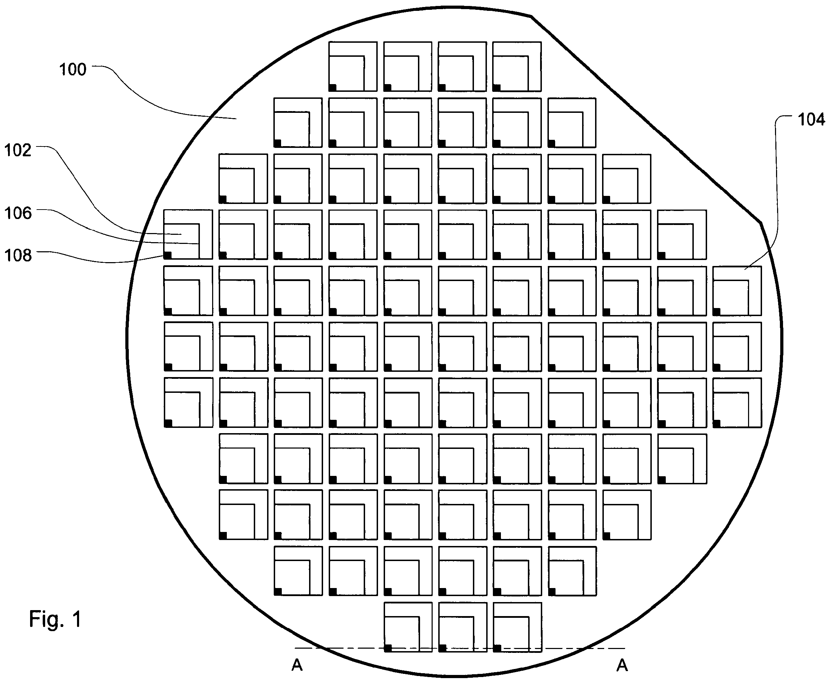

**Fig. 1** zeigt eine schematische Darstellung einer Aufsicht auf einen Waferverbund 100 mit optoelektronischen Halbleiterchips. Der Waferverbund 100 kann ein Halbleiterwafer sein. Der Halbleiterwafer beinhaltet ein Halbleitermaterial, wie beispielsweise Silizium. Bei der Herstellung eines optoelektronischen Halbleiterbauteils werden anstelle eines Siliziumsubstrats in der Regel III-V Verbindungshalbleiter verwendet, bspw. Galliumnitrid oder Indiumnitrid, die beispielsweise epitaktisch auf ein SiC-Substrat aufgewachsen sind. Bei der Prozessierung des Halbleiterwafers wird eine Halbleiterschichtfolge mit einer strahlungsemittierenden aktiven Zone hergestellt. Die aktive Zone weist dabei beispielsweise einen strahlungserzeugenden pn-Übergang oder eine strahlungserzeugende Einfach- oder Mehrfach-Quantenstruktur auf. Die vielfachen Strukturen und Verfahren zur Herstellung von Halbleiterbauelementen sind dem Fachmann bekannt und brauchen daher nicht erläutert werden. Die bei Anlegen einer elektrischen Spannung in der aktiven Zone erzeugte Strahlung wird über eine aktive Seite des Halbleiterchips ausgestrahlt. Die aktive Seite ist in der Aufsicht des Waferverbunds 100 dargestellt.

Der Waferverbund 100 kann ebenfalls ein Kunstwafer sein. Ein Kunstwafer wird aus vereinzelten Halbleiterchips erzeugt. Dazu können die Halbleiterchips auf einen gemeinsamen Träger aufgebracht werden und anschließend, beispielsweise mit einer Vergussmasse, auf diesem fixiert werden. Es ist ebenso möglich, dass der Kunstwafer eine Vielzahl von Aufnehmungen aufweist, in die die einzelnen Halbleiterchips mit der aktiven Seite nach oben eingebracht sind. Die Halbleiterchips in dem Kunstwafer stehen für eine weitere Prozessierung zur Verfügung.

Der Waferverbund 100 weist ein Chipraster auf, in dem ein erstes Halbleiterchip 102 und ein zweites Halbleiterchip 104 enthalten sind. Auf den Halbleiterchips sind die aktiven Seiten dargestellt. Auf diesen sind die jeweiligen vorderseitigen Kontaktflächen aufgebracht. So weist in der Darstellung der erste Halbleiterchip 102 auf seiner aktiven Seite einen Stromverteilungsanschluss 106 und einen Kontaktanschluss 108 auf. Der Stromverteileranschluss 106 dient dazu, einen zugeführten elektrischen Strom über die aktive Seite in die aktive Zone einzuspeisen. Der Kontaktanschluss 108, der elektrisch leitend mit dem Stromverteilungsanschluss verbunden ist, dient zu einer Kontaktierung mit einer Anschlusselektrode, beispielsweise über einen Bonddraht und einem Leiterrahmen (*leadframe*).

Auf die in dem Chipraster angeordneten Halbleiterchips wird nachfolgend ein Lumineszenzkonversionselement aufgebracht. Das Aufbringen wird nachfolgend anhand zweier Ausführungsbeispiele näher beschrieben.

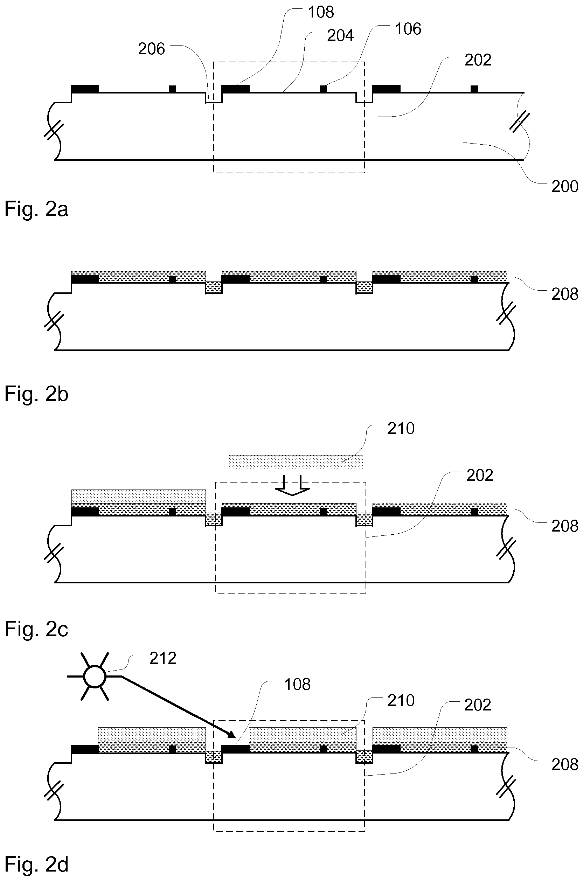

**Fig. 2a** bis **Fig. 2e** zeigen eine schematische Darstellung von Verfahrensschritten bei einem Herstellen eines optoelektronischen Halbleiterbauteils anhand eines Ausschnitts durch den in **Fig. 1** gezeigten Waferverbund entlang einer Schnittachse A-A für ein nicht erfindungsgemäßes Verfahren.

**Fig.2a** zeigt einen Querschnitt eines prozessierten Halbleiterwafers 200 mit einer Vielzahl an Halbleiterchips. Exemplarisch ist ein Halbleiterchip 202, bzw. ein Halbleiterplättchen, gekennzeichnet (gestrichelt dargestellt). Es weist eine aktive Seite 204 auf und ist durch einen Sägegraben 206 von einem links benachbarten Halbleiterchip getrennt. Der Sägegraben 206 ist ein Randbereich zwischen zwei Halbleiterchips. Der so definierte Abstand ergibt sich, da bei einem Auseinandersägen des Halbleiterwafers 200 ein Streifen weggesägt wird. Ebenfalls sind die Querschnitte des Stromverteileranschlusses 106 und des Kontaktanschlusses 108 auf der Oberseite, d. h. der Lichtaustrittsseite bzw. aktiven Seite, des Halbleiterchips 202 dargestellt. Die einzelnen Halbleiterchips können so bereits elektrisch kontaktiert und auf ihre spektralen Eigenschaften ausgemessen werden.

Nach dem Bereitstellen eines Halbleiterchips in dem Halbleiterwafer 200 wird auf der aktiven Seite der Halbleiterchips ein Ankopplungselement in Form einer Ankopplungsschicht 208 aufgebracht, wie in **Fig**. **2b** dargestellt. Die Ankopplungsschicht 208 bedeckt zumindest Teile der Oberfläche des Halbleiterwafers 200. Ebenso wäre es möglich, die Ankopplungsschicht 208 in Form von einzelnen Plättchen oder Tropfen auf einen jeweiligen Halbleiterchip aufzubringen.

In einem anschließenden in der **Fig. 2c** dargestellten Verfahrensschritt werden auf die aktiven Seiten der Halbleiterchips Lumineszenzkonversionselemente aufgebracht.

Dabei wird auf den Halbleiterchip 202 ein vorsortiertes Lumineszenzkonversionselement 210 aufgebracht. Das Lumineszenzkonversionselement 210 ist derart sortiert, dass für den Halbleiterchip 202 eine gewünschte spektrale Eigenschaft, beispielsweise ein bestimmter Farbort nach dem CIE-System, für die später emittierte Strahlung erzielt wird. Nach dem Aufbringen des Lumineszenzkonversionselements 210 wird dasselbe auf dem Halbleiterchip 202 fixiert. Dazu kann beispielsweise die Ankopplungsschicht ausgehärtet werden. Dies geschieht beispielsweise unter Anwendung von Wärme und/oder Strahlung.

In einem weiteren in der **Fig. 2d** dargestellten Verfahrensschritt wird der Kontaktanschluss 108 des Halbleiterchips freigelegt. Dies kann, wie in der Figur schematisch angedeutet, mit Hilfe von Laserablation erzielt werden. Unter Laserablation wird das Abtragen von Material von einer Oberfläche durch Beschuss mit gepulster Laserstrahlung verstanden. Dazu wird eine Laserquelle 212 bereitgestellt, aus der gepulste Laserstrahlung auf denjenigen Bereich des Lumineszenzkonversionselements 210 abgestrahlt wird, der den Kontaktanschluss 108 bedeckt. Als mögliche Laserquellen kommen dabei Kohlendioxid- oder UV-Laser in Betracht.

Durch die Laserablation wird das Material des Lumineszenzkonversionselements 210 und der Ankopplungsschicht 208 durch Verdampfen über den Kontaktanschluss 108 abgetragen. Um entstehende Verunreinigungen oder Rückstände des Lumineszenzkonversionselementmaterials auf dem Kontaktanschluss 108 zu beseitigen, können Reinigungsverfahren verwendet werden, wie beispielsweise mittels einer Wasserhochdruckreinigung und/oder eines O₂ - CF₄-Reinigungsplasmas.

Es sind ebenso andere Möglichkeiten zum Freilegen des Kontaktanschluss möglich. Beispielsweise können die Ankopplungsschicht 208 und das Matrixmaterial des Lumineszenzkonversionselements 210 aus photostrukurierbaren Materialien bestehen. Damit ist es möglich, den Kontaktanschluss 108 durch einen photolithographischen Prozess freizulegen.

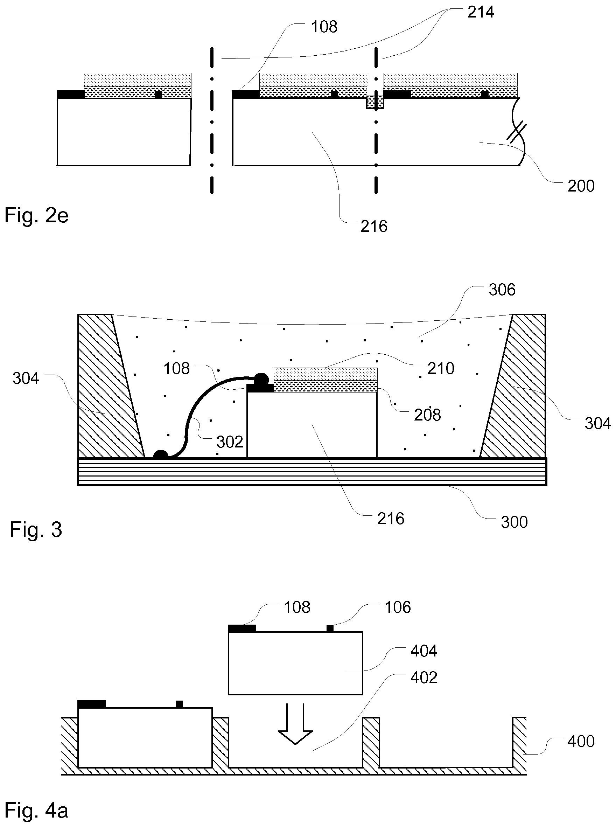

Nach dem Freilegen des Kontaktanschlusses 108 wird das Halbleiterbauelement 200 in einem in der **Fig. 2e** dargestellten Verfahrensschritt vereinzelt. Dazu wird der Halbleiterwafer 200 entlang von Sägelinien 214 in den Sägegraben zersägt. Es sind ebenso andere Vereinzelungsverfahren, wie Lasertrennung, möglich. Nach dem Vereinzeln entsteht ein vereinzelter optoelektronisches Halbleiterchip 216. Der vereinzelte Halbleiterchip 216 verfügt über einen verbindbaren Kontaktanschluss 108, so dass er vor einem Einbringen in ein Gehäuse bspw. auf eine Farbtemperatur des emittierten Spektrums getestet werden kann. Es ist möglich, dass der vereinzelte Halbleiterchip mit einem anderen Halbleiterchip in ein gemeinsames Gehäuse, als Multi-LED-Modul, eingebracht wird.

**Fig. 3** zeigt eine schematische Darstellung einer Ausführungsform eines optoelektronischen Halbleiterbauteils. Dabei ist ein vereinzeltes Halbleiterchip 216 auf einem Träger 300 aufgebracht. Der vereinzelte Halbleiterchip 216 ist mit einem Lumineszenzkonversionselement 210 bedeckt. Das Lumineszenzkonversionselement 210 ist mittels einer Ankopplungsschicht 208 auf einer aktiven Seite des vereinzelten Halbleiterchips 216 fixiert. Ein Kontaktanschluss 108 des vereinzelten Halbleiterchips 216 ist freigelegt. Der Kontaktanschluss 108 ist über einen Bonddraht 302 mit dem Träger 300 verbunden. Auf dem Träger 300 ist ein Reflektor 304 aufgebracht, der den vereinzelte Halbleiterchip 216 umfasst. In einer Aussparung des Reflektors 304 ist eine Vergussmasse 306 eingebracht, die den vereinzelte Halbleiterchip 216 und den Bonddraht 302 umschließt.

Der Träger 300 kann je nach Wahl des Gehäuses ein Leiterrahmen (*leadframe*) oder ein Substrat sein. Er dient beispielsweise zur mechanischen Stabilisierung des optoelektronischen Halbleiterbauteils und/oder zur elektrischen Verbindung des vereinzelten Halbleiterchips 216 mit äußeren elektrischen Kontakten.

Der Reflektor 304 dient zur Auskopplung von einer von dem vereinzelten Halbleiterchip 216 emittierten Strahlung. Er kann glatte Innenflächen aufweisen. Es ist ebenso möglich, dass die Innenflächen strukturiert sind, beispielsweise um eine bessere Abstrahlleistung des optoelektronischen Halbleiterbauteils zu erzielen. Die seitlichen Innenflächen können senkrecht in dem Reflektor 304 gebildet sein. Ebenso ist es möglich, dass die seitlichen Innenflächen schräg ausgebildet sind, beispielsweise in dem sie derart gebildet sind, dass sich die Aussparung hin zur Öffnung verbreitet. Die so gebildeten Ausformschrägen haben typischerweise einen Winkel von mehr als 4° abweichend von der Senkrechten zum Träger 300. Damit wird ebenfalls die Abstrahlleitung des optoelektronischen Halbleiterbauteils verbessert.

Die Vergussmasse 306 ist üblicherweise ein transparentes Material. Als Vergussmasse 306 kann z.B. ein transparentes Material verwendet sein, das UV-initiiert oder Lichtinitiiert kationisch härtende Eigenschaften besitzt. Für die Vergussmasse 306 kommen beispielsweise ein Silikon oder ein Epoxydharz in Betracht. Auch Acrylharze, wie PMMA, oder Silikonharze können verwendet sein. Die Vergussmasse 306 kann ein Diffusermaterial enthalten, um eine diffuse Strahlungsauskopplung von in den optischen Elementen erzeugter Strahlung zu ermöglichen. Dazu kann die Vergussmasse 306 Diffuserpartikel enthalten, die in der Vergussmasse 306 verteilt sind. Sie dienen dazu, auf sie treffende Strahlung, wie Licht, diffus zu streuen. Ebenso kann die Vergussmasse 306 Absorbermaterialien enthalten, um die optischen Eigenschaften des optoelektronischen Halbleiterbauteils je nach Bedarf zu beeinflussen.

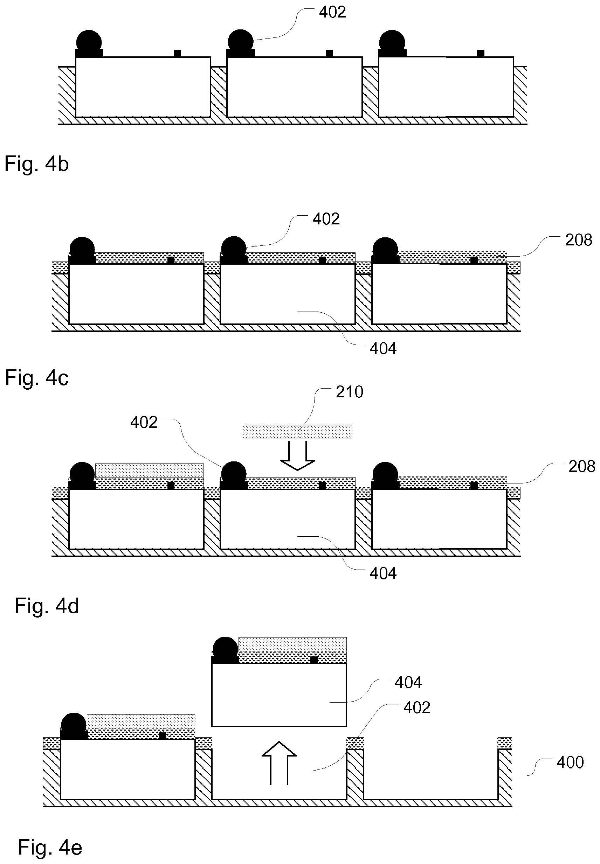

**Fig. 4a** bis **Fig. 4e** zeigen eine schematische Darstellung von Verfahrensschritten bei einem Herstellen eines optoelektronischen Halbleiterbauteils anhand eines Ausschnitts durch den in **Fig. 1** gezeigten Waferverbund entlang einer Schnittachse A-A eines erfindungsgemäßen Verfahrens. Soweit nicht weitere Angaben gemacht werden, können die nicht dargestellten Verfahrensschritte durch entsprechende Verfahrensschritte der **Fig. 2a** bis **Fig. 2e** ergänzt oder ersetzt werden.

Es wird zunächst ein prozessierter Halbleiterwafer bereitgestellt, so wie in **Fig. 2a** dargestellt. Das Ausführungsbeispiel der **Fig. 4a** bis **Fig. 4e** unterscheidet sich von dem nicht erfindungsgemäßen Verfahren der **Fig. 2a** bis **Fig. 2e** dadurch, dass der prozessierte Halbleiterwafer bereits in diesem Verfahrensschritt vereinzelt wird. Es werden somit vereinzelte Halbleiterchips bereitgestellt. Für jeden Halbleiterchip wird der Farbort bestimmt, der der jeweils der von dem Halbleiterbauelement emittierten Strahlung zuzuordnen ist. Entsprechend des Farborts können die Halbleiterchips sortiert werden. Ebenso ist es möglich, dass die Halbleiterchips nach anderen Kriterien, wie beispielsweise der Peakwellenlänge des Spektrums der Primärstrahlung sortiert werden.

**Fig. 4a** zeigt einen Kunstwafer 400. Der Kunstwafer 400 weist eine Aufnehmung 402 auf, in die ein prozessierter und vereinzelter Halbleiterchip 404 eingebracht wird. Damit steht der Kunstwafer 400 für eine weitere Prozessierung der eingebrachten Halbleiterchips bereit. Der Kunstwafer umfasst eine sortierte Auswahl an Halbleiterchips.

Alternativ dazu weist der Kunstwafer 400 lediglich Positionen auf, auf die der vereinzelte Halbleiterchip 404 angeordnet wird. Die derart angeordneten Halbleiterchips werden anschließend mittels einer Vergussmasse fixiert. Die Positionen können beispielsweise durch kleinere Aufnehmungen 402 gekennzeichnet sein.

Der Kunstwafer 400 kann analog der in den **Fig. 2b** bis **Fig. 2d** dargestellten Verfahrensschritten weiter verarbeitet werden. Ebenso ist es möglich, die im folgenden dargestellten Verfahrensschritte der **Fig. 4b** bis **Fig. 4d** entsprechend auf das Verfahren der **Fig. 2a** bis **Fig. 2e** zu übertragen.

In einem in der **Fig. 4b** dargestellten Verfahrensschritt wird auf den Kontaktanschluss 108 ein Lötkügelchen 402 (*bumps*) aufgebracht. Dieses kann aus einem Metall, wie Gold oder einer Legierung, wie bspw. einer Zinnlegierung bestehen. Damit wird eine spätere elektrische Kontaktierung vereinfacht. Anschließend wird in einem in der **Fig. 4c** dargestellten Verfahrensschritt eine Ankopplungsschicht 208 aufgebracht. Die Ankopplungsschicht 208 ist dabei derart dünn aufgetragen, dass die Lötkügelchen 402 aus ihr hervorragen. Ebenso wäre es möglich, die Ankopplungsschicht 208 in Form von einzelnen Plättchen oder Tropfen auf den Halbleiterchip 404 aufzubringen. Im Ergebnis ist das Lötkügelchen 402 nicht oder nur unwesentlich von der Ankopplungsschicht 208 bedeckt. Um das Lötkügelchen 402 nach dem Anbringen der Ankopplungsschicht 208 nur ein wenig von der so gebildeten Bauteiloberfläche herausragen zu lassen, kann in einem nachfolgenden Prozessschritt das Lotkügelchen 402 auf ein passende Dicke geschliffen werden.

Nach dem Aufbringen der Ankopplungsschicht 208 wird auf den Halbleiterchip 404 ein dem Farbort entsprechendes Lumineszenzkonversionselement 210 aufgebracht. Durch die Ankopplungsschicht 208 wird das Lumineszenzkonversionselement 210 an dem Halbleiterchip 404 analog zu dem Verfahrensschritt der **Fig. 2c** befestigt. Dieser Vorgang ist schematisch in der **Fig. 4c** dargestellt. Das Lumineszenzkonversionselement 210 weist dabei bevorzugt eine Öffnung auf, die das Lötkügelchen 402 freilässt, wenn das Lumineszenzkonversionselement 210 aufgebracht ist.

Anschließend kann der vereinzelter Halbleiterchip 404 aus der Aussparung 402 des Kunstwafers 400 entnommen und weiterverarbeitet werden. Dieser Verfahrensschritt ist schematisch in der **Fig. 4e** dargestellt. Nach einem elektrischen Kontaktieren und einem Einbringen in ein Gehäuse ist der Halbleiterchip 404 beispielhaft Teil eines in der **Fig. 3** dargestellten optoelektronischen Halbleiterbauteils.

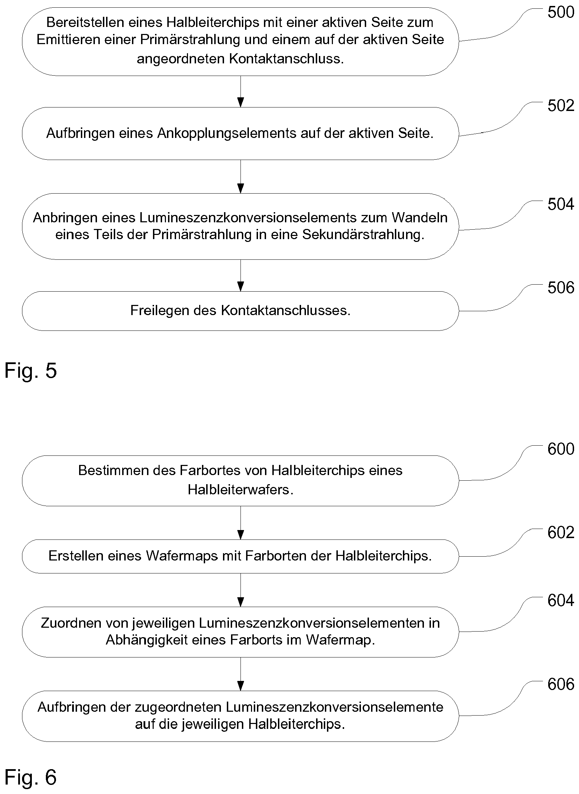

Die **Fig. 5** zeigt ein Ablaufdiagramm einer nicht erfindungsgemäßen Abwandlung eines Verfahrens zum Herstellen eines optoelektronischen Halbleiterbauteils.

In einem ersten Schritt 500 wird ein Halbleiterchip mit einer aktiven Seite zum Emittieren einer Primärstrahlung und einem auf der aktiven Seite angeordneten Kontaktanschluss bereitgestellt. Der Halbleiterchip kann Teil eines prozessierten Halbleiterwafers sein. Ebenso ist es möglich, dass ein bereits vereinzelter Halbleiterchip in einem Kunstwafer eingebracht ist oder einzeln verarbeitet wird.

In einem zweiten Schritt 502 wird auf der aktiven Seite ein Ankopplungselement aufgebracht. Dies kann beispielsweise durch das Aufbringen einer Ankopplungsschicht erfolgen. Ebenso können andere Mittel zum Ankoppeln eines Lumineszenzkonversionselements vorgesehen werden.

In einem dritten Schritt 504 wird ein Lumineszenzkonversionselement zum Wandeln eines Teils der Primärstrahlung in eine Sekundärstrahlung angebracht. Dabei wird das Lumineszenzkonversionselement auf der aktiven Seite des Halbleiterchips angeordnet. Es wird auf dieser mittels des Ankopplungselements fixiert.

Anschließend wird in einem Schritt 506 der Kontaktanschluss freigelegt. Vor oder nach dem Freilegen kann zudem ein Verfahrensschritt der Nachbehandlung erfolgen, in dem das Lumineszenzelement und/oder das Ankopplungselement zur Stabilisierung ausgehärtet bzw. verfestigt werden.

Durch dieses Herstellungsverfahren ist ein Halbleiterbauteil bereitgestellt, das bei Anlegen einer elektrischen Spannung sowohl im Bereich der Primärstrahlung als auch im Bereich der Sekundärstrahlung Strahlung emittiert. In einem weiteren, optionalen Schritt kann das emittierte Gesamtspektrum überprüft werden. Es steht zudem das Halbleiterbauelement ohne Gehäuse und somit für eine Vielzahl unterschiedlichster Anwendungen zur Verfügung.

Die **Fig. 6** zeigt ein Ablaufdiagramm eines Ausführungsbeispiels von Verfahrensschritten beim Herstellen eines optoelektronischen Halbleiterbauteils.

Dabei wird in einen ersten Verfahrensschritt 600 der jeweilige Farbort von optoelektronischen Halbleiterchips ermittelt, die zusammen einen Halbleiterwafer bilden. Nach der Ermittlung der Farborte kann in einem zweiten Verfahrensschritt 602 aufgrund dieser Information zusammen mit der Lage des dazugehörigen Halbleiterchips im Halbleiterwafer ein Wafermap mit Farborten der Halbleiterchips erstellt werden. Der Wafermap ist kann beispielsweise als Liste geführt sein, in der die ermittelten Daten und die Beziehung zwischen den ermittelten Daten abgelegt ist.

Mittels des Wafermaps ist es möglich, jedem der Halbleiterchips ein entsprechendes Lumineszenzkonversionselement zuzuordnen, um eine erstrebte Strahlungseigenschaft des Halbleiterbauteils zu erzielen. Die Zuordnung des Lumineszenzkonversionselements zu einem Halbleiterchip erfolgt in einem dritten Verfahrensschritt 604. Anschließend wird das zugeordnete Lumineszenzkonversionselement in einem Verfahrensschritt 606 auf den entsprechenden Halbleiterchip aufgebracht.

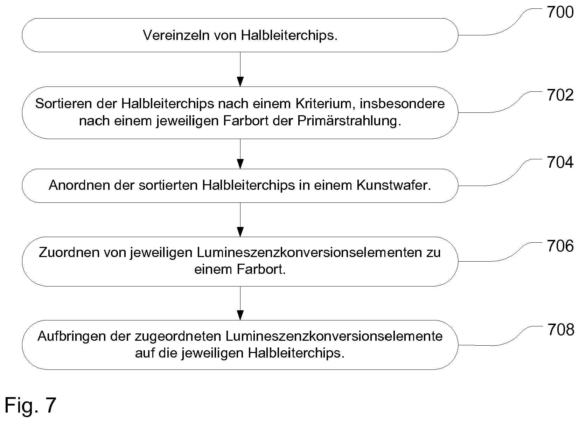

Die **Fig. 7** zeigt ein Ablaufdiagramm eines weiteren Ausführungsbeispiels von Verfahrensschritten beim Herstellen eines optoelektronischen Halbleiterbauteils.

In einem ersten Verfahrensschritt 700 werden die Halbleiterchips vereinzelt. Vor oder nach der Vereinzelung wird für jeden Halbleiterchip der Farborte der Primärstrahlung bestimmt. Es können auch andere physikalische Eigenschaften, beispielsweise die Peakwellenlänge der Primärstrahlung bestimmt werden. Anschließend werden die vereinzelten Halbleiterchips entsprechend der physikalischen Eigenschaften in einem zweiten Verfahrensschritt 702 sortiert. Dabei kann beispielsweise jeweils eine Gruppe von Halbleiterchips zusammengestellt werden, die innerhalb gewisser Toleranzen ähnliche physikalische Eigenschaften, beispielsweise einen ähnlichen Farbort der Primärstrahlung, aufweisen.

Die sortierten Halbleiterchips werden in einem dritten Verfahrensschritt 704 in einem Kunstwafer angeordnet. Bevorzugt werden in einem Kunstwafer Halbleiterchips einer zusammengestellten Gruppe angeordnet, so dass anschließend eine gemeinsame Weiterprozessierung erfolgen kann, ohne dass Variationen der Halbleiterchips berücksichtigt werden müssen.

In einem vierten Verfahrensschritt 706 werden Lumineszenzkonversionselemente einem bestimmten Farbort, bzw. einer bestimmten Gruppe von Halbleiterchips zugeordnet und in einem fünften Verfahrensschritt 708 auf letztere aufgebracht.

Es ist möglich, dass das Lumineszenzkonversionselement eine derartige Größe aufweist, dass es sich über mehrere Halbleiterchips erstreckt. Dies ist besonders vorteilhaft, wenn der Halbleiterwafer oder ein Waferverbund Domänen von Halbleiterchips aufweist, deren Farborte innerhalb einer vorgegebenen Toleranz liegen. Dementsprechend kann ein Lumineszenzkonversionselement einer Domäne zugeordnet und auf die Halbleiterchips der Domäne aufgebracht werden. Besonders vorteilhaft ist diese Variante bei einem Kunstwafer, in dem Halbleiterchips nach ihrem Farbort sortiert angeordnet sind. Ein einzelnes Lumineszenzkonversionselement bedeckt zunächst eine Vielzahl von Halbleiterchips und wird an diesen mittels des Ankopplungsmittels fixiert. In einem anschließend Schritt wird das Lumineszenzkonversionselement auf jedem Halbleiterchip, bspw. mittels einer Lasertrennung, zugeschnitten. Dies kann beispielsweise in einem Verfahrensschritt mit dem Vereinzeln der Halbleiterchips erfolgen. Es erfolgt in einer anderen Ausführungsform vor einem Vereinzeln der Halbleiterchips.

In Hinblick auf die beschriebenen Verfahren ist es möglich, dass die Verfahrensschritte der **Fig. 6** in Zusammenhang mit dem in den **Fig. 2a** bis **Fig. 2e** beschriebenen Verfahren und die Verfahrensschritte der **Fig. 7** in Zusammenhang mit der Ausführungsform des in den **Fig. 4a** bis **Fig. 4e** beschriebenen Verfahrens ausgeführt werden können.

### LITERATUR

In diesem Dokument sind die folgenden Veröffentlichungen zitiert:
[1] WO 97/50132, und
[2] WO 98/12757 A1.

## Patentansprüche

1. Verfahren zum Herstellen eines optoelektronischen Halbleiterbauteils, umfassend:
- Bereitstellen eines Halbleiterchips (202, 404) in einem Waferverbund mit einer aktiven Seite (204) zum Emittieren einer Primärstrahlung und einem auf der aktiven Seite (204) angeordneten Kontaktanschluss (108);
- Aufbringen eines Ankopplungselements (208) auf der aktiven Seite (204); und
- Anbringen eines Lumineszenzkonversionselements (210) zum Wandeln eines Teils der Primärstrahlung in eine Sekundärstrahlung auf dem Ankopplungselement (208), **dadurch gekennzeichnet, dass**
das Lumineszenzkonversionselement (210) entsprechend eines Farborts des Halbleiterchips (202, 404) ausgewählt ist,
des Weiteren umfassend:
- Ermitteln der Farborte der Halbleiterchips (202, 204),
- Vereinzeln der Halbleiterchips (202, 204) vor oder nach dem Ermitteln der Farborte,
- Sortieren der Halbleiterchips (202, 204) nach dem Farbort; und
- Anordnen der Halbleiterchips (202, 204) in einem Kunstwafer (400) basierend auf den Farborten der Halbleiterchips (202, 204) derart, dass jeweils eine Gruppe von Halbleiterchips (202, 204) zusammengestellt ist, die innerhalb vorgegebener Toleranzen einen ähnlichen Farbort aufweist,
sowie
- Aufbringen eines Lötkügelchens (402) auf den Kontaktanschluss (108) derart, dass das Lötkügelchen (402) von der anschließend aufgetragenen Ankopplungsschicht (208) nicht bedeckt wird, wobei das Lumineszenzkonversionselement (210) dabei eine Öffnung aufweist, die das Lötkügelchen (402) freilässt, wenn das Lumineszenzkonversionselement (210) aufgebracht ist.

2. Verfahren gemäß Patentanspruch 1, wobei der Waferverbund ein prozessierter Halbleiterwafer (200) ist.

3. Verfahren gemäß einem der vorangehenden Patentansprüche, wobei das Ankopplungselement (208) wenigstens eines der folgenden Materialien umfasst:
- Glas,
- Silikon
- Aluminiumoxid, oder
- einen Klebstoff.

4. Verfahren gemäß einem der vorangehenden Patentansprüche, wobei die Ankopplungsschicht (208) derart dünn aufgetragen wird, sodass die Lötkügelchen (402) aus der Ankopplungsschicht (208) hervorragen.

5. Verfahren gemäß einem der Patentansprüche 1 bis 3, wobei die Ankopplungsschicht (208) in Form von einzelnen Plättchen oder Tropfen auf den Halbleiterchip (404) aufgebracht wird.

6. Verfahren gemäß einem der vorangehenden Patentansprüche, wobei das Lotkügelchen (402) nach dem Aufbringen der Ankopplungsschicht (208) auf eine passende Dicke geschliffen wird.

7. Verfahren gemäß einem der vorangehenden Patentansprüche, wobei das Lotkügelchen (402) aus Gold oder einer Zinnlegierung besteht.

8. Verfahren gemäß einem der vorangehenden Patentansprüche, wobei der Kunstwafer (400) eine Aufnehmung (402) aufweist, in die der prozessierte und vereinzelte Halbleiterchip (404) eingebracht wird.

9. Verfahren gemäß dem vorangehenden Patentanspruch,
wobei der vereinzelte Halbleiterchip (404) nach dem Anbringen des Lumineszenzkonversionselements (210) aus der Aufnehmung (402) des Kunstwafers (400) entnommen wird.

10. Verfahren gemäß dem vorangehenden Patentanspruch,
wobei nachfolgend und nach einem elektrischen Kontaktieren und einem Einbringen in ein Gehäuse der Halbleiterchip (404) ein Teil eines optoelektronischen Halbleiterbauteils ist, wobei
- der Kontaktanschluss (108) über einen Bonddraht (302) mit einem Träger (300) verbunden ist,
- auf dem Träger (300) ein Reflektor (304) aufgebracht ist, der den vereinzelte Halbleiterchip (216) umfasst,
- in einer Aussparung des Reflektors (304) eine Vergussmasse (306) eingebracht ist, die den vereinzelte Halbleiterchip (216) und den Bonddraht (302) umschließt.

11. Verfahren gemäß dem vorangehenden Patentanspruch,
wobei
- der Reflektor (304) zur Auskopplung von einer von dem vereinzelten Halbleiterchip (216) emittierten Strahlung dient,
- der Reflektor (304) strukturierte Innenflächen aufweist,
- die Innenflächen schräg ausgebildet sind, sodass sich die Aussparung hin zu einer Öffnung verbreitet und so gebildete Ausformschrägen einen Winkel von mehr als 4° abweichend von der Senkrechten zum Träger (300) haben.

## Claims

1. Method for producing an optoelectronic semiconductor component, comprising:
- providing a semiconductor chip (202, 404) in a wafer assemblage with an active side (204) for emitting primary radiation and a contact connector (108) arranged on the active side (204);
- applying a coupling element (208) on the active side (204); and
- applying a luminescence conversion element (210) for converting some of the primary radiation into secondary radiation on the coupling element (208),
**characterized in that**
the luminescence conversion element (210) is selected according to a colour locus of the semiconductor chip (202, 404),
moreover comprising:
- ascertaining the colour loci of the semiconductor chips (202, 204),
- singulating the semiconductor chips (202, 204) before or after ascertaining the colour loci,
- sorting the semiconductor chips (202, 204) according to the colour locus; and
- arranging the semiconductor chips (202, 204) in an artificial wafer (400) on the basis of the colour loci of the semiconductor chips (202, 204) in such a way that a group of semiconductor chips (202, 204) is assembled in each case, said semiconductor chips having a similar colour locus within predetermined tolerances,
and also
- applying a solder ball (402) on the contact connector (108) in such a way that the solder ball (402) is not covered by the subsequently applied coupling layer (208), wherein the luminescence conversion element (210) has an opening in the process that leaves the solder ball (402) exposed after the luminescence conversion element (210) has been applied.

2. Method according to Patent Claim 1, wherein the wafer assemblage is a processed semiconductor wafer (200).

3. Method according to any one of the preceding patent claims, wherein the coupling element (208) comprises at least one of the following materials:
- glass,
- silicone,
- aluminium oxide, or
- an adhesive.

4. Method according to any one of the preceding patent claims, wherein the coupling layer (208) is applied so thin that the solder balls (402) protrude from the coupling layer (208).

5. Method according to any one of Patent Claims 1 to 3, wherein the coupling layer (208) is applied in the form of individual small plates or drops to the semiconductor chip (404) .

6. Method according to any one of the preceding patent claims, wherein the solder ball (402) is polished to a suitable thickness after the application of the coupling layer (208) .

7. Method according to any one of the preceding patent claims, wherein the solder ball (402) consists of gold or a tin alloy.

8. Method according to any one of the preceding patent claims, wherein the artificial wafer (400) has a receptacle (402), into which the processed and singulated semiconductor chip (404) is introduced.

9. Method according to the preceding patent claim, wherein the singulated semiconductor chip (404) is removed from the receptacle (402) of the artificial wafer (400) after the application of the luminescence conversion element (210).

10. Method according to the preceding patent claim, wherein, subsequently and after electrical contacting and introduction into a housing, the semiconductor chip (404) is part of an optoelectronic semiconductor component,
wherein
- the contact connector (108) is connected to a carrier (300) via a bond wire (302),
- a reflector (304) is applied to the carrier (300), said reflector comprising the singulated semiconductor chip (216),
- a potting compound (306) is introduced into a cutout of the reflector (304), said potting compound surrounding the singulated semiconductor chip (216) and the bond wire (302) .

11. Method according to the preceding patent claim, wherein
- the reflector (304) serves to couple out radiation emitted by the singulated semiconductor chip (216),
- the reflector (304) has structured inner surfaces,
- the inner surfaces have an inclined embodiment such that the cutout widens to a opening and shaping inclines thus formed have an angle that deviates by more than 4° from the perpendicular to the carrier (300).

## Revendications

1. Procédé pour la fabrication d'un composant semi-conducteur optoélectronique, comportant :
- la fourniture d'une puce semi-conductrice (202, 404) dans un composite en tranche avec une face active (204) pour l'émission d'un rayonnement primaire et une borne de contact (108) disposée sur la face active (204) ;
- l'application d'un élément de couplage (208) sur la face active (204) ; et
- le montage d'un élément de conversion de luminescence (210) pour la transformation d'une partie du rayonnement primaire en un rayonnement secondaire sur l'élément de couplage (208),
**caractérisé en ce que**
l'élément de conversion de luminescence (210) est sélectionné en fonction d'une localisation chromatique de la puce semi-conductrice (202, 404),
comportant en outre :
- la détermination des localisations chromatiques des puces semi-conductrices (202, 204),
- l'isolement des puces semi-conductrices (202, 204) avant ou après la détermination des localisations chromatiques,
- le tri des puces semi-conductrices (202, 204) selon la localisation chromatique ; et
- la disposition des puces semi-conductrices (202, 204) dans une tranche synthétique (400) sur la base des localisations chromatiques des puces semi-conductrices (202, 204) de telle sorte que respectivement un groupe de puces semi-conductrices (202, 204) qui possède une localisation chromatique semblable à l'intérieur de tolérances prédéfinies soit rassemblé,
ainsi que
- l'application d'une bille de soudure (402) sur la borne de contact (108) de telle sorte que la bille de soudure (402) ne soit pas recouverte par la couche de couplage (208) déposée ensuite, dans lequel l'élément de conversion de luminescence (210) comprend à cet effet une ouverture qui libère la bille de soudure (402) lorsque l'élément de conversion de luminescence (210) est appliqué.

2. Procédé selon la revendication de brevet 1, dans lequel le composite en tranche est une tranche semi-conductrice traitée (200).

3. Procédé selon l'une des revendications de brevet précédentes, dans lequel l'élément de couplage (208) comporte au moins l'un des matériaux suivants :
- du verre,
- de la silicone,
- de l'oxyde d'aluminium, ou
- une colle.

4. Procédé selon l'une des revendications de brevet précédentes, dans lequel la couche de couplage (208) est déposée de manière suffisamment fine pour que les billes de soudure (402) dépassent de la couche de couplage (208).

5. Procédé selon l'une des revendications de brevet 1 à 3, dans lequel la couche de couplage (208) est appliquée sous la forme de plaquettes ou gouttes individuelles sur la puce semi-conductrice (404).

6. Procédé selon l'une des revendications de brevet précédentes, dans lequel la bille de soudure (402) est polie après l'application de la couche de couplage (208) sur une épaisseur appropriée.

7. Procédé selon l'une des revendications de brevet précédentes, dans lequel la bille de soudure (402) est constituée d'or ou d'un alliage d'étain.

8. Procédé selon l'une des revendications de brevet précédentes, dans lequel la tranche synthétique (400) comprend un évidement (402) dans lequel est introduite la puce semi-conductrice (404) traitée et isolée.

9. Procédé selon la revendication de brevet précédente, dans lequel la puce semi-conductrice (404) isolée est extraite de l'évidement (402) de la tranche synthétique (400) après le montage de l'élément de conversion de luminescence (210).

10. Procédé selon la revendication de brevet précédente, dans lequel à la suite et après une mise en contact électrique et une introduction dans un boîtier, la puce semi-conductrice (404) est une partie d'un composant semi-conducteur optoélectronique, dans lequel
- la borne de contact (108) est reliée à un support (300) par l'intermédiaire d'un fil de connexion (302),
- un réflecteur (304) qui comporte la puce semi-conductrice (216) isolée est appliqué sur le support (300),
- une masse de coulée (306) qui entoure la puce semi-conductrice (216) isolée et le fil de connexion (302) est introduite dans une cavité du réflecteur (304).

11. Procédé selon la revendication de brevet précédente, dans lequel
- le réflecteur (304) sert au découplage d'un rayonnement émis par la puce semi-conductrice (216) isolée,
- le réflecteur (304) comprend des surfaces intérieures structurées,
- les surfaces intérieures sont conçues obliquement afin que la cavité s'élargisse jusqu'à une ouverture et les dépouilles ainsi formées présentent un angle de plus de 4° en s'écartant de la verticale par rapport au support (300).
